# EUROPEAN PATENT SPECIFICATION

(11) **EP 3 547 524 B1**
(45) Date of publication and mention of the grant of the patent: **04.11.2026**
(21) Application number: 16922473.0
(22) Date of filing: 28.11.2016
(51) Int. Cl.: H02M 7/48, H05K 7/20

(54) **POWER CONVERSION DEVICE**
STROMWANDLUNGSVORRICHTUNG
DISPOSITIF DE CONVERSION DE PUISSANCE

(43) Date of publication of application: 02.10.2019
(73) Proprietor: TMEIC Corporation, Tokyo 104-0031 (JP)
(72) Inventor: YOSHIDA, Naohiro, Tokyo 104-0031 (JP); TAKAHASHI, Nobuhiro, Tokyo 104-0031 (JP)
(74) Representative: Winter, Brandl - Partnerschaft mbB
(86) International application number: PCT/JP2016/085170
(87) International publication number: WO 2018/096677

(56) References cited:
- CA-A1- 2 536 756
- CA-A1- 2 782 378
- CN-U- 203 010 850
- JP-A- 2001 317 772
- JP-A- 2003 198 169
- JP-A- 2004 281 489
- JP-A- 2007 250 596
- JP-A- 2008 103 637
- JP-A- 2014 017 517
- JP-A- 2016 146 737
- JP-A- 2016 157 797
- JP-A- H03 175 484
- US-A1- 2010 291 850
- US-A1- 2011 036 554
- US-B2- 8 854 816

## Description

### Field

The present invention relates to a power conversion device.

### Background

PTL 1 discloses a power conversion device. The power conversion device includes a power conversion unit and a fan. The power conversion unit performs power conversion. A housing accommodates the power conversion unit. The fan generates airflow by rotating. The power conversion unit is cooled by the airflow.

### Citation List

### Patent Literature

[PTL 1] JP 2012-005242 A

### Summary

### Technical Problem

However, when the power conversion device discussed in PTL 1 is provided outdoors, wind from the outside of the housing may flow back into the housing. In this case, the power conversion unit is not cooled appropriately.

The present invention has been made to solve the above-mentioned problem. An object of the present invention is to provide a power conversion device capable of suppressing backflow of air into the housing. Further prior art with respect to cooling of power conversion devices is known from JP 2004 - 281 489 A, US 8 854 816 B2, JP 2008 - 103 637 A, JP 2007 - 250 596 A, US 2011/036 554 A1, CA 2 536 756 A1, CA 2 782 378 A1, JP 2014 - 017 517 A as well as CN 203 010 850 U, US 2010/0291850 A1 and JP 2003 198 169 A.

### Solution to Problem

The problem is solved by a power conversion device according to claim 1.

### Advantageous Effects of invention

According to these inventions, the airflow from the fan is variable depending on wind outside the housing. Therefore, it is possible to suppress air from flowing back into the housing.

### Brief Description of Drawings

[Fig. 1]

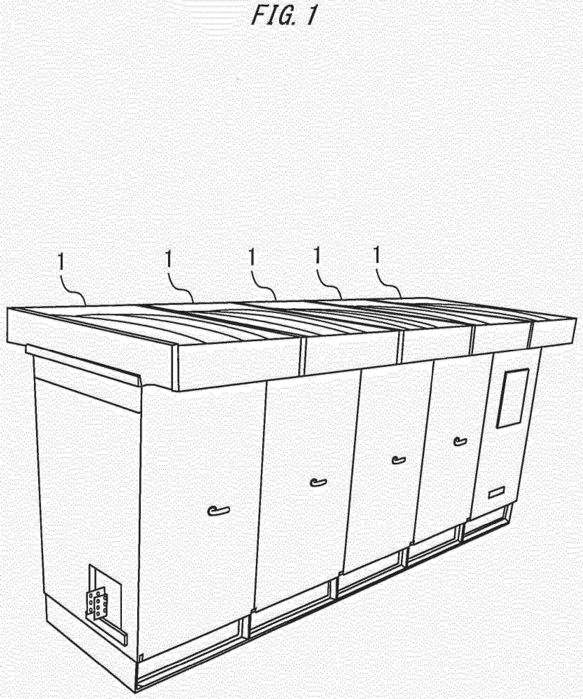

   Fig. 1 is a perspective view illustrating a power conversion device according to a first embodiment of the present invention.
[Fig. 2]

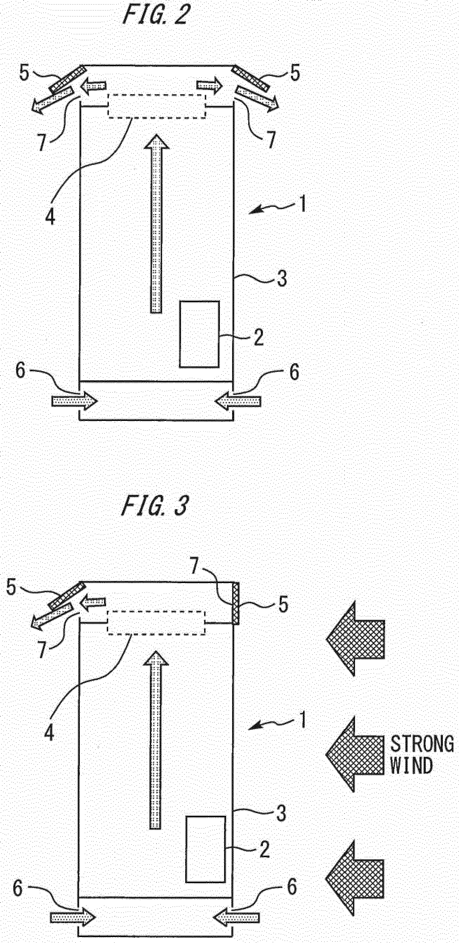

   Fig. 2 is a diagram illustrating a longitudinal section of an essential part of the power conversion device according to the first embodiment of the present invention.
[Fig. 3]
   Fig. 3 is a diagram illustrating a longitudinal section of the essential part of the power conversion device according to the first embodiment of the present invention.
[Fig. 4]

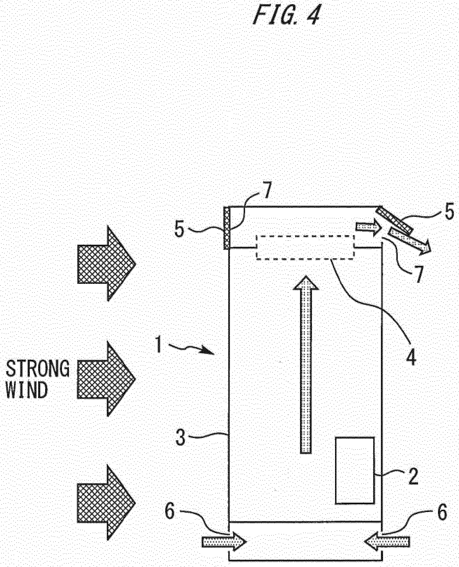

   Fig. 4 is a diagram illustrating a longitudinal section of the essential part of the power conversion device according to the first embodiment of the present invention.
[Fig. 5]

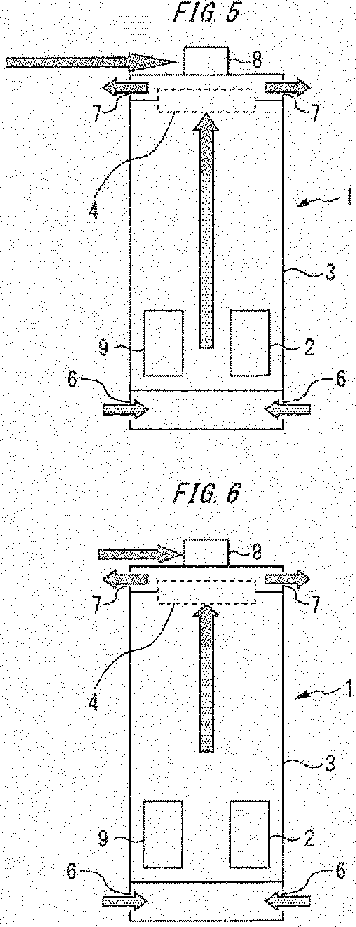

   Fig. 5 is a diagram illustrating a longitudinal section of an essential part of a power conversion device according to a second embodiment of the present invention.
[Fig. 6]
   Fig. 6 is a diagram illustrating a longitudinal section of the essential part of the power conversion device according to the second embodiment of the present invention.
[Fig. 7]

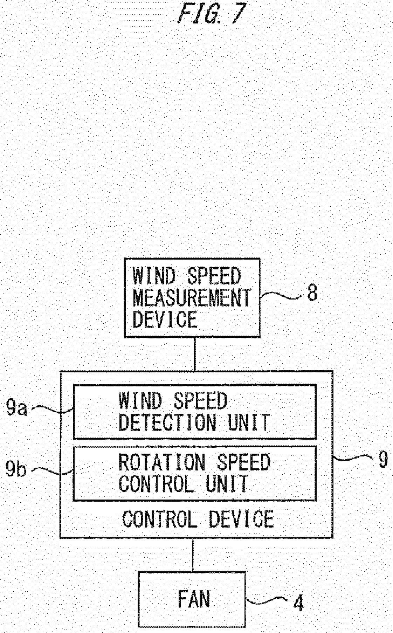

   Fig. 7 is a block diagram illustrating a control device of the power conversion device according to the second embodiment of the present invention.
[Fig. 8]

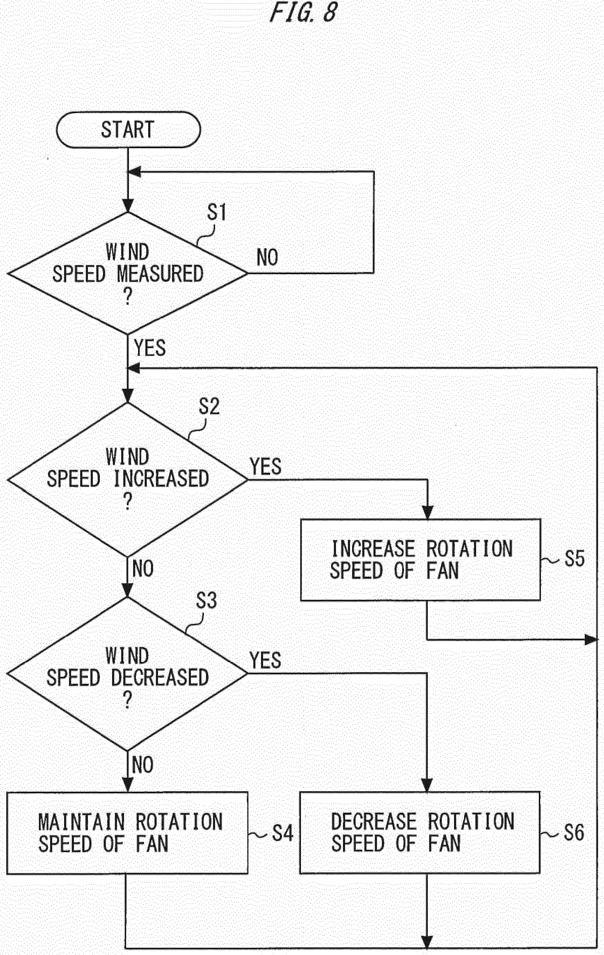

   Fig. 8 is a flowchart schematically illustrating an operation of the control device of the power conversion device according to the second embodiment of the present invention.
[Fig. 9]

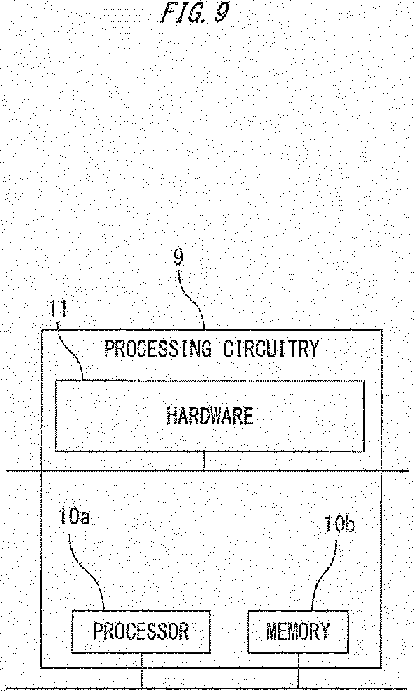

   Fig. 9 is a diagram illustrating a hardware configuration of the control device of the power conversion device according to the second embodiment of the present invention.

### Description of Embodiments

Embodiments of the present invention will be described with reference to attached drawings. In the drawings, the same or corresponding parts are denoted by the same reference numerals. Duplicated explanations of these parts will be simplified or omitted appropriately.

### First Embodiment

Fig. 1 is a perspective view illustrating a power conversion device according to a first embodiment of the present invention.

In Fig. 1, a plurality of power conversion devices 1 is provided outdoors. The plural power conversion devices 1 are adjacent to each other.

Next, airflow will be described with reference to Figs. 2 to 4.

Figs. 2 to 4 are diagrams illustrating longitudinal sections of an essential part of the power conversion device according to the first embodiment of the present invention.

As illustrated in Fig. 2, each of the plurality of power conversion devices 1 includes a power conversion unit 2, a housing 3, a fan 4, and a pair of covers 5.

For example, an input part of the power conversion unit 2 is electrically connected to an output part of a solar panel (not illustrated). For example, an output part of the power conversion unit 2 is electrically connected to a power system (not illustrated).

For example, the outer shape of the housing 3 is formed into a rectangular parallelepiped shape. The housing 3 accommodates the power conversion unit 2. For example, the housing 3 accommodates the power conversion unit 2 on one side thereof. For example, the housing 3 has a pair of air inlets 6 and a pair of air outlets 7.

One of the pair of air inlets 6 is provided at a lower portion on the front side of the housing 3. For example, one of the pair of air inlets 6 is formed into a rectangular shape. For example, one of the pair of air inlets 6 has its longer direction as the horizontal direction. The other of the pair of air inlets 6 is provided at a lower portion on the rear side of the housing 3. For example, the other of the pair of air inlets 6 is formed into a rectangular shape. For example, the other of the pair of air inlets 6 has its longer direction as the horizontal direction.

One of the pair of air outlets 7 is provided at an upper portion on the front side of the housing 3. For example, one of the pair of air outlets 7 is formed into a rectangular shape. For example, one of the pair of air outlets 7 has its longer direction as the horizontal direction. The other of the pair of air outlets 7 is provided at an upper portion on the rear side of the housing 3. For example, the other of the pair of air outlets 7 is formed into a rectangular shape. For example, the other of the pair of air outlets 7 has its longer direction as the horizontal direction.

The fan 4 is provided inside the housing 3. For example, the fan 4 is provided just under an upper surface of the housing 3.

One of the pair of covers 5 is provided at one of the pair of air outlets 7. For example, an upper edge of one of the pair of covers 5 is supported to be rotatable with respect to the housing 3. The other of the pair of covers 5 is provided at the other of the pair of air outlets 7. For example, an upper edge of the other of the pair of covers 5 is supported to be rotatable with respect to the housing 3.

In each power conversion device 1, the power conversion unit 2 performs power conversion. For example, the power conversion unit 2 receives DC power from the solar panel. The power conversion unit 2 converts the DC power into AC power. The power conversion unit 2 supplies the AC power to the power system.

At this time, the fan 4 generates airflow. As a result, outside air flows into the housing 3 via the pair of air inlets 6. Subsequently, the air passes through the fan 4. Thereafter, the air moves toward the pair of air outlets 7.

In a normal state, the generated airflow is stronger than airflow moving from the outside of the housing 3 toward one of the pair of air outlets 7. The generated airflow is stronger than airflow moving from the outside of the housing 3 toward the other of the pair of air outlets 7.

At this time, at one of the pair of air outlets 7, one of the pair of covers 5 is pushed toward the outside of the housing 3 by the airflow. As a result, one of the pair of covers 5 rotates about its upper edge. Therefore, one of the pair of covers 5 is brought into an opened state with respect to one of the pair of air outlets 7. In this state, the airflow flows to the outside of the housing 3 via one of the pair of air outlets 7.

At the other of the pair of air outlets 7, the other of the pair of covers 5 is pushed toward the outside of the housing 3 by the airflow. As a result, the other of the pair of covers 5 rotates about its upper edge. Therefore, the other of the pair of covers 5 is brought into an opened state with respect to the other of the pair of air outlets 7. In this state, the airflow flows to the outside of the housing 3 via the other of the pair of air outlets 7.

As illustrated in Fig. 3, in a case where wind from the front side of the housing 3 is strong, the above-mentioned airflow is weaker than airflow moving from the outside of the housing 3 toward one of the pair of air outlets 7.

At this time, at one of the pair of air outlets 7, one of the pair of covers 5 is pushed toward the inside of the housing 3 by the wind. As a result, one of the pair of covers 5 is pressed against one of the pair of air outlets 7. Therefore, one of the pair of covers 5 is brought into a closed state with respect to one of the pair of air outlets 7. In this state, the airflow does not go out via one of the pair of air outlets 7 to the outside of the housing 3.

At the other of the pair of air outlets 7, the other of the pair of covers 5 is pushed toward the outside of the housing 3 by the airflow. As a result, the other of the pair of covers 5 rotates about its upper edge. Therefore, the other of the pair of covers 5 is brought into an opened state with respect to the other of the pair of air outlets 7. In this state, the airflow goes out via the other of the pair of air outlets 7 to the outside of the housing 3.

As illustrated in Fig. 4, in a case where wind from the rear side of the housing 3 is strong, the above-mentioned airflow is weaker than airflow moving from the outside of the housing 3 toward the other of the pair of air outlets 7.

At this time, at one of the pair of air outlets 7, one of the pair of covers 5 is pushed toward the outside of the housing 3 by the airflow. As a result, one of the pair of covers 5 rotates about its upper edge. Therefore, one of the pair of covers 5 is brought into an opened state with respect to one of the pair of air outlets 7. In this case, part of the airflow goes out via one of the pair of air outlets 7 to the outside of the housing 3.

At the other of the pair of air outlets 7, the other of the pair of covers 5 is pushed toward the inside of the housing 3 by the wind. As a result, the other of the pair of covers 5 is pressed against the other of the pair of air outlets 7. Therefore, the other of the pair of covers 5 is brought into a closed state with respect to the other of the pair of air outlets 7. In this case, the airflow does not go out via the other of the pair of air outlets 7 to the outside of the housing 3.

According to the first embodiment described above, when the airflow from the fan 4 is weaker than the airflow moving from the outside of the housing 3 toward the air outlet 7 of the housing 3, the cover 5 is brought into a closed state with respect to the air outlet 7. Therefore, it is possible to suppress air from flowing back into the housing 3 without increasing the rotation speed of the fan 4.

At this time, no active device such as an actuator is required. Therefore, the power conversion device 1 that is highly reliable and low in cost can be realized.

### Second Embodiment

Figs. 5 and 6 are diagrams each illustrating a longitudinal section of an essential part of a power conversion device according to a second embodiment of the present invention. In the drawings, the same or corresponding parts as those in the first embodiment are denoted by the same reference numerals. Explanations of these parts will be omitted.

As illustrated in Figs. 5 and 6, in the second embodiment, the power conversion device 1 does not have the covers 5. The power conversion device 1 includes a wind speed measurement device 8 and a control device 9.

The wind speed measurement device 8 is provided outside the housing 3. For example, the wind speed measurement device 8 is provided on the upper surface of the housing 3. The control device 9 is provided inside the housing 3. For example, the control device 9 is provided on the other side of the housing 3. An input part of the control device 9 is electrically connected to an output part of the wind speed measurement device 8. An output part of the control device 9 is electrically connected to an input part of the fan 4.

The wind speed measurement device 8 measures the wind speed outside the housing 3. When the wind speed measurement device 8 measures the wind speed, the control device 9 controls the rotation speed of the fan 4 based on the wind speed.

For example, as illustrated in Fig. 5, when the wind speed increases, the control device 9 increases the rotation speed of the fan 4. As a result, an appropriate amount of air flows out via the pair of air outlets 7 to the outside of the housing 3.

For example, as illustrated in Fig. 6, when the wind speed decreases, the control device 9 decreases the rotation speed of the fan 4. As a result, an appropriate amount of air flows out via the pair of air outlets 7 to the outside of the housing 3.

Next, the control device 9 will be described with reference to Fig. 7.

Fig. 7 is a block diagram illustrating the control device of the power conversion device according to the second embodiment of the present invention.

As illustrated in Fig. 7, the control device 9 includes a wind speed detection unit 9a and a rotation speed control unit 9b.

The wind speed detection unit 9a detects the wind speed measured by the wind speed measurement device 8. The rotation speed control unit 9b controls the rotation speed of the fan 4 based on the wind speed detected by the wind speed detection unit 9a.

Next, an operation of the control device 9 will be schematically illustrated with reference to Fig. 8.

Fig. 8 is a flowchart schematically illustrating the operation of the control device of the power conversion device according to the second embodiment of the present invention.

In step S1, the control device 9 determines whether the wind speed measurement device 8 has measured the wind speed. When the wind speed measurement device 8 has not measured the wind speed in step S1, the control device 9 performs the operation of step S1. When the wind speed measurement device 8 has measured the wind speed in step S1, the control device 9 performs an operation of step S2.

In step S2, the control device 9 determines whether the wind speed measured by the wind speed measurement device 8 has increased.

When the wind speed measured by the wind speed measurement device 8 has not increased in step S2, the control device 9 performs an operation of step S3. In step S3, the control device 9 determines whether the wind speed measured by the wind speed measurement device 8 has decreased.

When the wind speed measured by the wind speed measurement device 8 has not decreased in step S3, the control device 9 performs an operation of step S4. In step S4, the control device 9 maintains the rotation speed of the fan 4. Subsequently, the control device 9 performs the operation of step S2.

When the wind speed measured by the wind speed measurement device 8 has increased in step S2, the control device 9 performs an operation of step S5. In step S5, the control device 9 increases the rotation speed of the fan 4. Subsequently, the control device 9 performs the operation of step S2.

When the wind speed measured by the wind speed measurement device 8 has decreased in step S3, the control device 9 performs an operation of step S6. In step S6, the control device 9 decreases the rotation speed of the fan 4. Subsequently, the control device 9 performs the operation of step S2.

According to the second embodiment described above, when the wind speed measurement device 8 has measured the wind speed, the control device 9 controls the rotation speed of the fan 4 based on the wind speed. Therefore, it is possible to suppress air from flowing back into the housing 3 without excessively increasing the rotation speed of the fan 4. As a result, the lifetime of the fan 4 can also be prolonged.

Next, an example of the control device 9 will be described with reference to Fig. 9.

Fig. 9 is a diagram illustrating a hardware configuration of the control device of the power conversion device according to the second embodiment of the present invention.

Each function of the control device 9 can be realized by a processing circuitry. For example, the processing circuitry includes at least one processor 10a and at least one memory 10b. For example, the processing circuitry includes at least one dedicated hardware 11.

When the processing circuitry includes the at least one processor 10a and the at least one memory 10b, each function of the control device 9 can be realized by software, firmware, or a combination of software and firmware. At least one of the software and the firmware is described as a program. At least one of the software and the firmware is stored in the at least one memory 10b. The at least one processor 10a realizes each function of the control device 9 by reading and executing the program stored in the at least one memory 10b. The at least one processor 10a may be referred to as a central processing unit (CPU), a central processor, a processor, an arithmetic unit, a microprocessor, a microcomputer, or a DSP. For example, the at least one memory 10b is a nonvolatile or volatile semiconductor memory such as RAM, ROM, flash memory, EPROM, or EEPROM, a magnetic disk, a flexible disk, an optical disk, a compact disk, a mini disk, a DVD, or the like.

When the processing circuitry includes the at least one dedicated hardware 11, the processing circuitry can be realized by, for example, a single circuit, a composite circuit, a programmed processor, a parallel programmed processor, ASIC, FPGA, or a combination thereof. For example, each function of the control device 9 can be respectively realized by the processing circuitry. For example, each function of the control device 9 can be collectively realized by the processing circuitry.

Part of each function of the control device 9 may be realized by the dedicated hardware 11 and the rest may be realized by software or firmware. For example, functions of the wind speed detection unit 9a may be realized by the processing circuitry as the dedicated hardware 11, and functions other the functions of the wind speed detection unit 9a may be realized by the at least one processor 10a reading and executing the program stored in the at least one memory 10b.

In this manner, the processing circuitry realizes each function of the control device 9 by the hardware 11, software, firmware, or a combination thereof.

In the power conversion device 1 described in the first embodiment, the control device 9 according to the second embodiment may be used. In this case, even when the cover 5 is broken, it is possible to suppress air from flowing back into the housing 3 without excessively increasing the rotation speed of the fan 4.

Further, the positions of the air inlets 6 and the air outlets 7 may be appropriately set. For example, the air inlets 6 may be provided at an upper portion of the housing 3. At this time, the air outlets 7 may be provided at a lower portion of the housing 3. In this case, inflow of dusts from the ground can be prevented.

### Industrial Applicability

As mentioned above, the power conversion device according to the present invention can be used for a system suppressing air from flowing back into the housing.

### Reference Signs List

1 Power conversion device
2 Power conversion unit
3 Housing
4 Fan
5 Cover
6 Air inlet
7 Air outlet
8 Wind speed measurement device
9 Control device
9a Wind speed detection unit
9b Rotation speed control unit
10a Processor
10b Memory
11 Hardware

## Claims

1. A power conversion device comprising:
a power conversion unit (2) configured to perform power conversion;
a housing (3) accommodating the power conversion unit (2) and having a pair of front and rear air inlets (6) provided below the power conversion unit (2) and a pair of front and rear air outlets (7) provided above the power conversion unit (2),
a fan (4) provided inside the housing (3) to generate airflow in such a manner that air flows to an outside of the housing (3) via the pair of front and rear air outlets (7) after flowing into the housing (3) via the pair of front and rear air inlets (6); and
a pair of front and rear covers (5) provided at each of the pair of front and rear air outlets (7),
wherein an upper edge part of the pair of front and rear covers (5) is supported to be rotatable with respect to the housing (3),
wherein, in a case where wind from the outside of the housing (3) toward one of the pair of front and rear outlets (7) is stronger than the airflow generated by the fan (4), the cover (5) provided on one of the pair of front and rear outlets (7) is configured to be brought into a closed state with respect to the one of the pair of front and rear outlets (7), and the cover (5) provided on another of the pair of front and rear outlets (7) is configured to be brought into an opened state with respect to the another of the pair of front and rear outlets (7).

2. The power conversion device according to claim 1, further comprising:
a wind speed measurement device (8) configured to measure a wind speed outside the housing (3), and
a control device (9) configured to, when the wind speed measurement device (8) has measured the wind speed, control the rotation speed of the fan (4) based on the wind speed.

## Patentansprüche

1. Energieumwandlungsvorrichtung, mit:
einer Energieumwandlungseinheit (2), die konfiguriert ist, eine Energieumwandlung durchzuführen;
einem Gehäuse (3), das die Energieumwandlungseinheit (2) aufnimmt und ein Paar eines vorderen und eines hinteren Lufteinlasses (6), die unter der Energieumwandlungseinheit (2) vorgesehen sind, und ein Paar eines vorderen und eines hinteren Luftauslasses (7), die über der Energieumwandlungseinheit (2) vorgesehen sind, aufweist,
einem Gebläse (4), das innerhalb des Gehäuses (3) vorgesehen ist, um einen Luftstrom derart zu erzeugen, dass Luft über das Paar des vorderen und des hinteren Luftauslasses (7) zu einer Außenseite des Gehäuses (3) strömt, nachdem sie über das Paar des vorderen und des hinteren Lufteinlasses (6) in das Gehäuse (3) geströmt ist; und
einem Paar einer vorderen und einer hinteren Abdeckung (5), die jeweils am Paar des vorderen und des hinteren Luftauslasses (7) vorgesehen sind,
wobei ein oberer Randteil des Paars der vorderen und der hinteren Abdeckung (5) so gelagert ist, dass er in Bezug auf das Gehäuse (3) drehbar ist,
wobei in einem Fall, in dem Wind von der Außenseite des Gehäuses (3) zu einem von dem vorderen oder dem hinteren Auslass (7) stärker ist als der durch das Gebläse (4) erzeugte Luftstrom, die Abdeckung (5), die an dem einen von dem vorderen und dem hinteren Auslass (7) vorgesehen ist, konfiguriert ist, in einen geschlossenen Zustand in Bezug auf den einen des Paars von vorderen und hinteren Auslässen (7) gebracht zu werden, und die Abdeckung (5), die an dem anderen des Paars von dem vorderen und dem hinteren Auslass (7) vorgesehen ist, konfiguriert ist, in einen geöffneten Zustand in Bezug auf den anderen des Paars von dem vorderen und dem hinteren Auslass (7) gebracht zu werden.

2. Energieumwandlungsvorrichtung nach Anspruch 1, ferner mit:
einer Windgeschwindigkeitsmessvorrichtung (8), die konfiguriert ist, eine Windgeschwindigkeit außerhalb des Gehäuses (3) zu messen, und
einer Steuervorrichtung (9), die konfiguriert ist, wenn die Windgeschwindigkeitsmessvorrichtung (8) die Windgeschwindigkeit gemessen hat, die Drehzahl des Gebläses (4) basierend auf der Windgeschwindigkeit zu steuern.

## Revendications

1. Dispositif de conversion de puissance comprenant :
une unité de conversion de puissance (2) configurée pour effectuer une conversion de puissance ;
un boîtier (3) accueillant l'unité de conversion de puissance (2) et présentant une paire d'entrées d'air avant et arrière (6) prévues au-dessous l'unité de conversion de puissance (2) et une paire de sorties d'air avant et arrière (7) situées au-dessus de l'unité de conversion de puissance (2),
un ventilateur (4) prévu à l'intérieur du boîtier (3) pour générer un flux d'air de telle sorte que de l'air s'écoule vers l'extérieur du boîtier (3) par la paire de sorties d'air avant et arrière (7) après s'être écoulé dans le boîtier (3) par la paire d'entrées d'air avant et arrière (6) ; et
une paire de couvercles avant et arrière (5) prévus à chacune de la paire sorties d'air avant et arrière (7),
dans lequel une partie de bord supérieure de la paire de couvercles avant et arrière (5) est supportée pour pouvoir tourner par rapport au boîtier (3),
dans lequel dans un cas dans lequel du vent provenant de l'extérieur du boîtier (3) vers l'une de la paire de sorties avant et arrière (7) est plus fort que le flux d'air généré par le ventilateur (4), le couvercle (5) prévu sur une certaine des deux sorties avant et arrière (7) est configuré pour être amené dans un état fermé par rapport à la certaine de la paire de sorties avant et arrière (7), et le couvercle (5) prévu sur l'autre des deux sorties avant et arrière (7) est configuré pour être amené dans un état ouvert par rapport à l'autre de la paire de sorties avant et arrière (7).

2. Dispositif de conversion de puissance selon la revendication 1, comprenant en outre
un dispositif de mesure de vitesse de vent (8) configuré pour mesurer une vitesse de vent à l'extérieur du boîtier (3), et
un dispositif de commande (9) configuré pour, lorsque le dispositif de mesure de vitesse de vent (8) a mesuré la vitesse de vent, commander la vitesse de rotation du ventilateur (4) sur la base de la vitesse de vent.
